# EUROPEAN PATENT APPLICATION

(11) **EP 4 776 007 A1**
(43) Date of publication of application: **15.07.2026**
(21) Application number: 24895165.9
(22) Date of filing: 06.12.2024
(51) Int. Cl.: G01R 31/367, G01R 31/382, G01R 31/392

(54) **METHOD FOR PREDICTING CYCLE PERFORMANCE OF BATTERY, AND DEVICE AND STORAGE MEDIUM**

(30) Priority: 10.10.2024 CN 202411413506
(71) Applicant: Eve Energy Co. Ltd., Huizhou, Guangdong 516000 (CN)
(72) Inventor: DUAN, Yulong, Huizhou, Guangdong 516006 (CN); AI, Siwei, Huizhou, Guangdong 516006 (CN); LI, Maoqi, Huizhou, Guangdong 516006 (CN); DU, Jinyan, Huizhou, Guangdong 516006 (CN); ZHANG, Zhongyuan, Huizhou, Guangdong 516006 (CN); CHEN, Weitao, Huizhou, Guangdong 516006 (CN); LUO, Haoyu, Huizhou, Guangdong 516006 (CN)
(74) Representative: Herrero & Asociados, S.L.
(86) International application number: PCT/CN2024/137552
(87) International publication number: WO 2026/076808

(57) **Abstract**

The present disclosure provides a method, equipment, and storage medium for predicting battery cycle performance. The method for predicting battery cycle performance includes: acquiring a performance characteristic of a battery to be tested from historical usage data of the battery to be tested; and performing prediction processing on the performance characteristic based on a cycle performance prediction model which is pre-trained to obtain a cycle performance indicator of the battery to be tested.

## Description

The present application claims the priority of Chinese Patent Application No. 2024114135065, filed to the China Patent Office on October 10, 2024, the disclosure of which is hereby incorporated by reference in their entireties into the present application.

### TECHNICAL FIELD

The present disclosure belongs to the technical field of batteries, and particularly relates to a method, equipment, and storage medium for predicting battery cycle performance.

### BACKGROUND

With the advancement of technology in society, batteries are required in various fields, such as power tools, electric vehicles, drones, and more. In the optimization design, manufacturing, and application of batteries, battery cycle performance is an important evaluation metric.

### SUMMARY

### Technical Problem

To predict battery cycle performance, the Arrhenius equation is commonly used to derive battery lifespan under different temperatures. However, the Arrhenius equation primarily focuses on impact of a single external environmental factor on the battery lifespan, which results in lower accuracy in predicting the battery cycle performance.

### Technical Solution

In a first aspect, the present disclosure provides a method for predicting battery cycle performance. The method includes:
acquiring a performance characteristic of a battery to be tested from historical usage data of the battery to be tested;
performing a prediction processing on the performance characteristic based on a cycle performance prediction model which is pre-trained to obtain a cycle performance indicator of the battery to be tested.

In a second aspect, the present disclosure provides a battery cycle performance prediction device, including:
a feature acquisition module, configured to acquire a performance characteristic of a battery to be tested from historical usage data of the battery to be tested; and
an indicator prediction module, configured to perform a prediction processing on the performance characteristic based on a cycle performance prediction model which is pre-trained to obtain a cycle performance indicator of the battery to be tested.

In a third aspect, the present disclosure provides an electronic equipment, including:
a processor; and
a memory, which stores one or more computer programs, and when executed by the processor, the one or more computer programs cause the processor to perform the method as described in any of the preceding aspects.

In a fourth aspect, the present application provides a computer-readable storage medium storing one or more programs, which when executed by a processor, the method as described in any of the preceding aspects can be performed.

### Benefit Effects

The beneficial effects provided by the present disclosure are as follows. The embodiments of the present disclosure consider a performance characteristic related to an inherent performance of a battery to be tested and perform prediction processing on the performance characteristic through a cycle performance prediction model which is pre-trained to obtain a cycle performance feature of the battery to be tested. Compared to the related art, which only considers impact of external environmental factors on battery cycle performance, the present disclosure reduces prediction error for cycle performance of the battery to be tested by adopting the performance characteristic related to the inherent performance of the battery to be tested and excluding features irrelevant to the inherent performance of the battery to be tested. Additionally, embodiments of the present disclosure also perform a prediction processing on the cycle performance of the battery to be tested by training a cycle performance prediction model, which effectively handles a plurality of features related to the inherent performance of the battery to be tested, improving accuracy and reliability of battery cycle performance prediction.

### BRIEF DESCRIPTION OF THE DRAWINGS

FIG. 1 is a flowchart illustrating a method for predicting battery cycle performance according to embodiments of the present disclosure.
FIG. 2 is a block diagram of a cycle performance prediction model according to embodiments of the present disclosure.
FIG. 3 is a flowchart illustrating a method for training the cycle performance prediction model according to embodiments of the present disclosure.
FIG. 4 is a block diagram of a battery cycle performance prediction device according to embodiments of the present disclosure.
FIG. 5 is another block diagram of the battery cycle performance prediction device according to embodiments of the present disclosure.
FIG. 6 is a block diagram of an electronic equipment according to embodiments of the present disclosure.

### DETAILED DESCRIPTION OF THE PRESENT DISCLOSURE

To improve accuracy of battery cycle performance prediction, embodiments of the present disclosure introduce a machine learning model and predict a cycle performance indicator of a battery by training the machine learning model. To elaborate on the solution provided by the embodiments of the present disclosure, a method for predicting battery cycle performance will be discussed in two aspects: model training and model application.

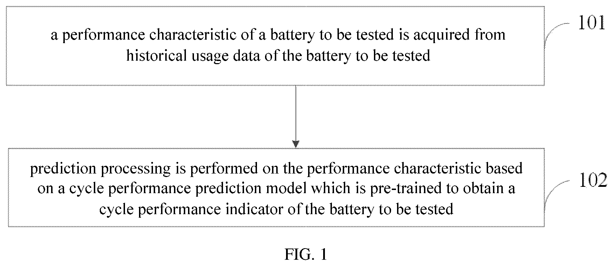

In terms of the model application, please refer to FIG. 1. FIG. 1 is a flowchart illustrating a method for predicting battery cycle performance according to embodiments of the present disclosure. The method for predicting battery cycle performance can be applied to a battery cycle performance prediction device provided by embodiments of the present disclosure, and the battery cycle performance prediction device can be integrated into an electronic equipment. The electronic equipment can be a smartphone, computer, tablet, or the like.

The method for predicting battery cycle performance provided by the embodiments of the present disclosure can include operations 101-102 described as follows.

In the operation 101, a performance characteristic of a battery to be tested is acquired from historical usage data of the battery to be tested.

Here, a battery that needs to undergo cycle performance prediction is referred to as the battery to be tested. The battery to be tested can be a lithium-ion battery. After using the battery to be tested for a period of time, corresponding usage data is generated, which is referred to as the historical usage data.

In some embodiments, the performance characteristic of the battery to be tested is obtained from the historical usage data of the battery to be tested, including the following operations.

The historical usage data of the battery to be tested is acquired. The historical usage data includes charge/discharge voltage data, charge/discharge current data, battery capacity data, temperature data, and pressure data at each historical cycle count.

Data cleaning is performed on the historical usage data to obtain processed historical usage data.

Based on charge/discharge voltage data, charge/discharge current data, and battery capacity data at each historical cycle count in the processed historical usage data, the performance characteristic of the battery to be tested is determined.

For example, the historical usage data of the battery to be tested includes both data related to inherent performance of the battery to be tested and data unrelated to the inherent performance of the battery to be tested. The data related to the inherent performance of the battery to be tested includes, for example, battery capacity data, charge/discharge voltage data, charge/discharge current data, charge/discharge power data, historical cycle count (also referred to as charge/discharge usage count), internal resistance data, etc. The data unrelated to the inherent performance of the battery to be tested includes, for example, temperature data, pressure data, etc.

Once the historical usage data of the battery to be tested is obtained, the data related to the inherent performance of the battery to be tested can be selected from the historical usage data. For example, the historical cycle count, charge/discharge voltage data, charge/discharge current data, and battery capacity data.

Afterward, the selected data can undergo normalization or standardization to obtain the performance characteristic of the battery to be tested and to ensure that the data related to the inherent performance of the battery to be tested is within a same numerical range, so the performance characteristics of the battery to be tested can be used as input for a subsequent model.

Additionally, after obtaining the historical usage data of the battery to be tested, the data cleaning can be performed on the historical usage data to obtain the processed historical usage data. Then, the data related to the inherent performance of the battery to be tested is selected from the historical usage data. Finally, the selected data is normalized or standardized to obtain the performance characteristic of the battery to be tested.

The data cleaning performed on the historical usage data includes partially removing outliers or missing values in the historical usage data, or correcting the outliers and filling in the missing values.

In the embodiments of the present disclosure, by obtaining the performance characteristic related to the inherent performance of the battery to be tested from the historical usage data, multiple performance characteristics are integrated to predict the cycle performance of the battery to be tested, enhancing reliability and stability of the cycle performance prediction of the battery to be tested. Additionally, by using the performance characteristic related to the inherent performance of the battery to be tested, impact of irrelevant factors on a prediction result is eliminated, thereby improving accuracy of the cycle performance prediction of the battery to be tested.

In step 102, prediction processing is performed on the performance characteristic based on a cycle performance prediction model which is pre-trained to obtain a cycle performance indicator of the battery to be tested.

In the embodiments of the present disclosure, a machine learning model is first constructed and then trained to predict the cycle performance indicator of the battery to be tested.

The machine learning model constructed can be a regression model, which is trained using a sample battery training set, and the trained machine learning model is referred to as the cycle performance prediction model.

In the embodiments of the present disclosure, by training the regression model, an unknown cycle performance indicator of the battery to be tested can be predicted based on a known performance characteristic, improving efficiency of the cycle performance prediction of the battery to be tested. Additionally, influence of complex factors from various aspects on the cycle performance of the battery can be comprehensively considered, with strong data processing capabilities. Compared to empirical models and electrochemical models used in related technologies, this method effectively handles relationships between performance characteristics of the battery to be tested and is applicable to predicting the cycle performance of most batteries.

The empirical models and electrochemical models are described as follows. An empirical model is a battery degradation model constructed based on a large amount of experimental data of the battery. The empirical model relies on specific condition types and battery types, requiring high-quality processing of large amounts of experimental data of the battery. Therefore, it has limitations such as poor generalizability and difficulties in handling experimental data. An electrochemical model is a mathematical model constructed based on electrochemical principles and material characteristics of the battery. The electrochemical model simulates internal chemical reactions and physical processes of the battery to predict the cycle performance. However, the electrochemical model is highly complex, require large computational resources, and involve numerous difficult-to-obtain electrochemical parameters during practical use.

In using the cycle performance prediction model, the performance characteristic is input into the cycle performance prediction model for prediction processing, and output is a prediction result of the cycle performance of the battery to be tested. The prediction result is represented by the cycle performance indicator. The cycle performance indicator refers to a parameter used to represent the cycle performance of the battery to be tested, such as cycle count, battery capacity, etc.

In the embodiments of the present disclosure, by training the cycle performance prediction model, the cycle performance prediction model is designed to predict the cycle performance indicator of the battery to be tested based on the performance characteristic of the battery to be tested. The cycle performance prediction model can be applied to most batteries and has high data processing efficiency.

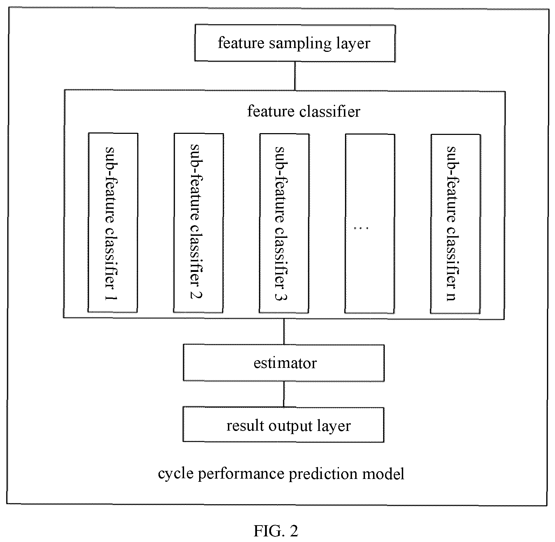

The cycle performance prediction model provided by the embodiments of the present disclosure is described as follows. Please refer to FIG. 2, which is a block diagram of a cycle performance prediction model according to embodiments of the present disclosure. The cycle performance prediction model includes a feature sampling layer, a feature classifier, an estimator, and a result output layer, which are connected in sequence. The feature classifier includes a plurality of sub-feature classifiers arranged in parallel with each other.

Specifically, the feature sampling layer is configured to extract a plurality of sub-features from the performance characteristic and randomly input the plurality of sub-features into the plurality of sub-feature classifiers. Each of the plurality of sub-feature classifiers receives a respective one of the plurality of sub-features. The each of the plurality of sub-feature classifiers is configured to perform feature classification processing on the respective one of the plurality of sub-features and obtain a feature classification result. The estimator is configured to aggregate the feature classification result from the each of the plurality of sub-feature classifiers to generate an estimated result. The result output layer is configured to make a prediction based on the estimated result.

For example, the performance characteristic may include historical cycle count, historical charge/discharge voltage, and historical charge/discharge current, while the cycle performance indicator may be measured by battery capacity.

The prediction processing is performed on the performance characteristic based on the cycle performance prediction model which is pre-trained to obtain the cycle performance indicator of the battery to be tested, including the following operations.

The feature sampling layer selects historical charge/discharge currents and historical charge/discharge voltages at a plurality of distinct historical cycle counts from the performance characteristic as input to the feature classifier.

The each of the plurality of sub-feature classifiers performs the feature classification processing on a respective one of the historical charge/discharge currents and a respective one of the historical charge/discharge voltages at a respective one of the plurality of distinct historical cycle counts which are input to the each of the plurality of sub-feature classifiers, to obtain the feature classification result for the each of the plurality of sub-feature classifiers.

The estimator aggregates the feature classification result from the each of the plurality of sub-feature classifiers to generate the estimated result.

The result output layer performs the prediction processing on the estimated result to obtain a target battery capacity at a target cycle count.

In this process, by inputting the performance characteristic of the battery to be tested into the feature sampling layer, the feature sampling layer divides features from the performance characteristic. For example, in the performance characteristic, the historical charge/discharge current is denoted as In, the historical charge/discharge voltage is denoted as Vn, and the historical cycle count is denoted as N. According to a test sequence of the battery to be tested, the performance characteristic can be represented as: (N=1, I1, V1), (N=2, I2, V2), ... , (N, In, Vn).

The feature sampling layer randomly inputs a set of performance characteristic from a test sequence into one of the sub-feature classifiers. For example, the pair (N=2,I2,V2) could be input into sub-feature classifier F1, and (N=5,I5,V5) could be input into sub-feature classifier F10.

Each sub-feature classifier then predicts a corresponding battery capacity as the feature classification result, where the battery capacity is denoted as Cn, and n represents the historical cycle count. The estimator establishes a relationship between N-In-Vn-Cn based on each predicted battery capacity. The result output layer uses the estimated result from the estimator and the target cycle count to predict the target battery capacity at the target cycle count. The target cycle count is selected to be greater than a maximum historical cycle count.

Additionally, through long-term observation of battery test results, in this embodiment, the performance characteristic from first 300 cycles of the battery can be selected as input to the cycle performance prediction model to predict the battery capacity at 600 cycles.

Exemplarily, the cycle performance prediction model provided in this embodiment can include a random forest machine learning model. During prediction process of the battery cycle performance in this model, multiple performance characteristics related to the inherent performance of the battery to be tested are comprehensively considered, and variation patterns of the performance characteristics with cycle count are captured, improving accuracy of prediction of the cycle performance of the battery to be tested.

In some embodiments, the result output layer performs the prediction processing on the estimated result to obtain the target battery capacity at the target cycle count, including the following operations.

The result output layer performs the prediction processing on the estimated result to obtain a predicted battery capacity at the target cycle count.

An average temperature of temperature data at each historical cycle count is calculated.

The predicted battery capacity is adjusted based on the average temperature to obtain the target battery capacity.

The battery to be tested has corresponding temperature data for the each historical cycle count. By calculating an average of the temperature data at the each historical cycle count, the average temperature is obtained to adjust the predicted battery capacity. It can be understood that before calculating the average temperature, a maximum value or a minimum value from the temperature data at the each historical cycle count can be excluded to ensure the average temperature is closer to a long-term operating temperature of the battery to be tested.

When adjusting the predicted battery capacity based on the average temperature, an absolute difference between the average temperature and a preset temperature is first determined. An adjustment magnitude to the predicted battery capacity is determined based on the absolute difference. For example, when the average temperature is greater than the preset temperature, the predicted battery capacity is reduced, and the target battery capacity is obtained. A reduction in the predicted battery capacity is positively correlated with the absolute difference. That is, the larger the absolute difference, the greater the reduction in the predicted battery capacity, resulting in the target battery capacity being much smaller than the predicted capacity. Conversely, the smaller the absolute difference, the smaller the reduction in the predicted battery capacity, resulting in the target battery capacity being slightly smaller than the predicted capacity.

In this embodiment, the preset temperature can be a temperature at which the battery to be tested exhibits the best cycle performance during use. The preset temperature can be obtained through experimental measurement, manually set, or it can be set as room temperature, depending on actual requirements.

As an alternative embodiment, the average temperature can be pre-set with a temperature level, the temperature level corresponds to a temperature coefficient. By multiplying the temperature coefficient by the predicted battery capacity, the target battery capacity can be obtained. In this case, the higher the average temperature, the lower the temperature level it falls into, and the smaller the temperature coefficient, which is less than or equal to 1.

In this embodiment, the result output layer first processes the estimated result to preliminarily obtain the predicted battery capacity at the target cycle count. Then, considering influence of external environmental factors on the battery to be tested, the temperature data of the battery to be tested is used to adjust the predicted battery capacity. This adjustment ensures a more accurate evaluation of the target battery capacity in actual usage environment of the battery to be tested, making the resulting target battery capacity more precise and facilitating subsequent accurate assessment of the cycle performance of the battery to be tested.

In some embodiments, the estimator aggregates the feature classification result from the each of the plurality of sub-feature classifiers to generate the estimated result, including the following operations.

For each of the plurality of sub-feature classifiers, the estimator determines a count weight to a respective one of the plurality of distinct historical cycle counts.

The estimator performs weighted processing on the count weight and the feature classification result corresponding to the each of the plurality of sub-feature classifiers to obtain a weighted classification result for the each of the plurality of sub-feature classifiers.

The estimator aggregates the weighted classification result for the each of the plurality of sub-feature classifiers to obtain the estimated result.

Predefined count weights can be set for different historical cycle counts, with the count weight being proportional to a value of the historical cycle count. The larger the historical cycle count, the larger the count weight; the smaller the historical cycle count, the smaller the count weight. After inputting performance characteristics at different historical cycle counts into corresponding sub-feature classifiers, a weighted classification result output by each sub-feature classifier can first be processed by the estimator, followed by an aggregation of each weighted classification result of a respective one sub-feature classifier to obtain the estimated result. For example, when the historical cycle count for sub-feature classifier 1 is the 5th cycle, and the weighted classification result is a1, while the count weight for the 5th historical cycle count is f5, the weighted classification result for the 5th cycle of the sub-feature classifier 1 would be a1×f5.

Additionally, a gradient difference for each count weight can be determined based on a value of the target cycle count. For example, the larger the target cycle count, the smaller the gradient difference for each count weight. Conversely, the smaller the target cycle count, the larger the gradient difference for each count weight.

This embodiment takes into account that the target battery capacity at the target cycle count, which is predicted later, is most influenced by the feature classification result of the historical cycle count closest to the target cycle count. Therefore, by setting corresponding count weights for different historical cycle counts and assigning weights to different feature classification results via the estimator, accuracy of the estimated result can be significantly improved.

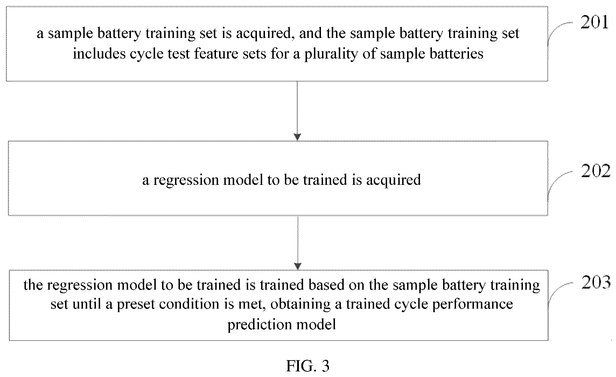

In terms of the model training, please refer to FIG. 3, which illustrates a method for training the cycle performance prediction model according to embodiments of the present disclosure, which includes the following operations 201-203.

In the operation 201, a sample battery training set is acquired. The sample battery training set includes cycle test feature sets for a plurality of sample batteries. Each of the cycle test feature sets of a respective one of the plurality of sample batteries includes an inherent performance characteristic of the respective one of the plurality of sample batteries measured for a single test cycle.

For example, a part of sample battery test data is pre-extracted from a test database to create the sample battery training set. The sample batteries are numerous, and each sample battery has a plurality of cycle test feature sets. Each of the plurality of cycle test feature sets includes test cycle count N, charge/discharge voltage Vn, charge/discharge current In, battery capacity Cn, and other inherent performance-related features for the sample battery. The single test cycle corresponds to one charge/discharge voltage, charge/discharge current, and battery capacity.

In some embodiments, the sample battery training set is created, including the following operations 2011-2013.

In the operation 2011, cycle test data of each of the plurality of sample batteries within a preset period is acquired. The each of the plurality of sample batteries has one set of test data for the each single test cycle.

For example, the preset period may range from the 0th to the 600th cycle test. For each test cycle, the sample battery generates one set of single test data, which includes charge/discharge current, charge/discharge voltage, battery capacity, temperature, pressure, etc. In this example, the sample battery undergoes 600 test cycles, producing 600 sets of single test data.

In the operation 2012, data cleaning is performed on the cycle test data of the each of the plurality of sample batteries to obtain processed cycle test data.

The data cleaning performed on the cycle test data of the each of the plurality of sample batteries involves handling outliers and missing values. By removing portions of N sets of single test data for each sample battery that contain outliers or missing values, or by correcting the outliers and filling in the missing values, the processed cycle test data for each sample battery is obtained. In this way, data quality of the cycle test data can be improved, thereby enabling better effect when the cycle test data is applied.

In the operation 2013, from the processed cycle test data, inherent performance characteristics of the plurality of sample batteries are determined to construct a sample battery feature set, and the sample battery training set is selected from the sample battery feature set.

For example, cycle count, charge/discharge current, charge/discharge voltage, and battery capacity are extracted from the single test data of each sample battery to create the sample battery feature set, while excluding influence of temperature, pressure, and other factors in the single test data. In constructing the sample battery feature set from the single test data, normalization or standardization of charge/discharge current, charge/discharge voltage, battery capacity, cycle count, and other factors can be applied to reduce data dimension.

In the operation 202, a regression model to be trained is acquired.

Specifically, a machine learning model that is trained without use of the sample battery feature set is referred to as the regression model, while a machine learning model that is trained using the sample battery feature set is referred to as the cycle performance prediction model.

The regression model utilizes the performance characteristics of the battery under known continuous cycle counts to predict the cycle performance indicators of the battery for future unknown cycle counts, allowing for the prediction of the cycle performance of the battery, facilitating optimization during production and manufacturing processes.

In some embodiments, operation 202 further includes operations 2021-2024.

In the operation 2021, a plurality of candidate hyperparameter combinations are acquired by traversing the regression model utilizing a network search algorithm.

The grid search algorithm (Grid Search CV) is an optimization method for hyperparameters. It works by setting a range of possible values for each hyperparameter and trying all possible combinations to identify the plurality of candidate hyperparameter combinations.

In this embodiment, the network search algorithm is employed to identify all candidate hyperparameter combinations for the regression model. This enables parallel evaluation of each candidate hyperparameter combination, thereby improving the optimization efficiency of hyperparameters for the regression model and accelerating model training. Moreover, flexible combinations of different hyperparameters can be achieved, which enhances the comprehension capability of the regression model's hyperparameters and facilitates improvement of model prediction performance.

In the operation 2022, a cross-validation algorithm is adopted to partition a sample battery dataset into the sample battery training set and a sample battery validation set, and performance validation on the regression model is performed under each of the plurality of candidate hyperparameter combinations to obtain a performance validation result for each candidate hyperparameter.

Through the cross-validation algorithm, the sample battery dataset is partitioned into the sample battery training set and the sample battery validation set. The sample battery training set is used to train the regression model, while the sample battery validation set evaluates performance of the regression model. The optimal hyperparameter combination is then determined based on the performance validation result.

In this embodiment, the cross-validation algorithm may adopt 3-fold cross-validation. During implementation, the sample battery dataset can first be randomly divided into three equal subsets. In a first iteration, a first subset is used as the sample battery training set, and a second subset and a third subset are merged to serve as the sample battery validation set. In a second iteration, the second subset is used as the sample battery training set, and the first subset and the third subset are merged to serve as the sample battery validation set. In a third iteration, the third subset is used as the sample battery training set, and the first subset and the second subset are merged to serve as the sample battery validation set.

This embodiment employs the cross-validation method to adjust the hyperparameters of the regression model based on the performance validation result. For instance, when structure of the regression model is similar to the a random forest machine learning model, the number of trees and the number of features considered at each node split can be adjusted, with repeated iterations to optimize the hyperparameters. Furthermore, this method of dividing the sample battery training set and sample battery validation set reduces subjectivity and randomness of data division, avoids biases caused by unreasonable data partitioning, and maximizes use of information in the sample battery dataset, improving data utilization. Additionally, more comprehensive data usage can more accurately evaluate the model's performance, thereby selecting a best target hyperparameter combination to improve stability and generalization ability of the regression model.

In the operation 2023, based on the performance validation result, a target hyperparameter combination is determined from the plurality of candidate hyperparameter combinations.

By adjusting parameter values in the plurality of candidate hyperparameter combinations according to the performance validation result, the target hyperparameter combination with the best performance is obtained.

In this embodiment, a combination of network search algorithm and cross-validation algorithm is used to determine the target hyperparameter combination of the regression model. This not only improves model's feature selection ability but also enhances model's generalization ability. Moreover, the regression model considers correlation between multiple features and influence of time factor, allowing for handling of multi-dimensional features, resulting in good prediction accuracy and stability.

In the operation 2024, the regression model to be trained is constructed according to the target hyperparameter combination.

Based on the target hyperparameter combination, specific structure of the regression model can be determined, such as the number of trees, maximum depth, minimum samples required for a split, etc. Subsequently, the regression model is trained using a large sample feature dataset, which can effectively enhance the model's subsequent prediction performance.

In the operation 203, the regression model to be trained is trained based on the sample battery training set until a preset condition is met, obtaining a trained cycle performance prediction model.

In this embodiment, the sample battery training set here can be larger or more up-to-date than the sample battery training set used in the above cross-validation. The preset condition can include training the regression model with the sample battery training set until the preset number of training iterations is reached, or training until differences between predicted values and actual values of the regression model is minimized, etc. These conditions can be set based on practical needs.

In some embodiments, the operation 203 includes the following operations.

An inherent performance feature of the regression model to be trained is acquired, including battery capacity, cycle count, charge/discharge voltage, and charge/discharge current.

The cycle count, charge/discharge voltage, and charge/discharge current of each single test cycle in the sample battery training set are taken as input of the regression model, the battery capacity of the each single test cycle is taken as output of the regression model, and the regression model is trained until the preset condition is met, obtaining the cycle performance prediction model.

When training the regression model, the charge/discharge voltage and charge/discharge current corresponding to each cycle count are used as model input, and the battery capacity corresponding to the each cycle count is used as model output. By learning relationship between the model input and model output, the trained cycle performance prediction model is obtained.

In some embodiments, when training the regression model, the method further includes the following operations.

Performance of the cycle performance prediction model is assessed using an evaluation metric. The evaluation metric includes at least one of mean squared error, root mean squared error, and coefficient of determination.

Alternatively, the performance of the cycle performance prediction model is evaluated by a scatter plot. The scatter plot presents predicted values versus actual values of the cycle performance prediction model.

Specifically, the performance of the cycle performance prediction model can be evaluated. This embodiment provides two evaluation approaches. When using the evaluation metric for evaluation, any one of the following metrics can be employed.

Mean squared error (MSE) is calculated by first obtaining differences between the predicted values and the actual values of the cycle performance prediction model, then computing an average of a sum of squared differences. The smaller the MSE, the smaller prediction error of the cycle performance prediction model. A larger MSE indicates a larger prediction error of the cycle performance prediction model. A smaller MSE suggests that the predicted values are closer to the actual values, and the cycle performance prediction model has stronger predictive capability.

Root mean squared error (RMSE) is a square root of the mean squared error and is similarly used to measure the prediction error of the cycle performance prediction model. RMSE is easier to interpret and understand compared to MSE. A smaller RMSE indicates higher prediction accuracy of the cycle performance prediction model.

The coefficient of determination (R²) is a statistical metric used to assess goodness of fit of the cycle performance prediction model to data. R² values range from 0 to 1. The closer the R² value is to 1, the better the cycle performance prediction model fits the data, meaning the cycle performance prediction model can explain more of the variability of the data. An R² value of 1 means the cycle performance prediction model perfectly fits the data, while an R² value of 0 means the cycle performance prediction model cannot explain variability of the data.

In this embodiment, use of the evaluation metric to assess the performance of the cycle performance prediction model helps quantify accuracy of the model's prediction and the model's degree of fit to the data, further facilitating intuitive performance evaluation or model tuning of the cycle performance prediction model.

Specifically, when the model performance of the cycle performance prediction model is found to be poor based on the evaluation metric, the above-mentioned evaluation metric can be minimized as a target, and parameters of the cycle performance prediction model can be adjusted to accurately improve the predictive performance of the cycle performance prediction model.

When evaluating the performance of the cycle performance prediction model through the scatter plot, by labeling corresponding positions of the actual values and predicted values on the scatter plot, it helps better understand distribution of the actual values and predicted values and subsequent trends, providing an intuitive view of prediction effect of the cycle performance prediction model and the differences between the actual values and predicted values. For example, when most points are concentrated near a trend line, it indicates that prediction of the cycle performance prediction model is accurate. When the points are scattered on both sides of the trend line, it indicates that the prediction error of the cycle performance prediction model is large.

Once relationship between distribution of scatter points and the trend line is visually assessed, model parameters of the cycle performance prediction model can be adjusted to ensure that the scatter points are closely aligned with the trend line, thereby improving the model performance.

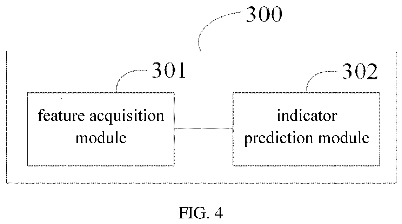

Refer to FIG. 4, which is a block diagram of a battery cycle performance prediction device according to embodiments of the present disclosure. The battery cycle performance prediction device 300 may include a feature acquisition module 301, a model acquisition module 303, and an indicator prediction module 302.

The feature acquisition module 301 is configured to acquire a performance characteristic of a battery to be tested from historical usage data of the battery to be tested.

The indicator prediction module 302 is configured to prediction processing on the performance characteristic based on a cycle performance prediction model which is pre-trained to obtain a cycle performance indicator of the battery to be tested.

In one embodiment, the feature acquisition module 301 is further configured to:
acquire the historical usage data of the battery to be tested, wherein the historical usage data includes charge/discharge voltage data, charge/discharge current data, battery capacity data, temperature data, and pressure data at each historical cycle count;
perform data cleaning on the historical usage data to obtain processed historical usage data; and
determine the performance characteristic of the battery to be tested based on the charge/discharge voltage data, charge/discharge current data, and battery capacity data at the each historical cycle count in the processed historical usage data.

In one embodiment, the cycle performance prediction model includes a feature sampling layer, a feature classifier, an estimator, and a result output layer, the feature sampling layer, the feature classifier, the estimator, and the result output layer are connected in sequence, and the feature classifier includes a plurality of sub-feature classifiers arranged in parallel with each other; the performance characteristic includes historical cycle count, historical charge/discharge voltage, and historical charge/discharge current, and the cycle performance indicator is measured by battery capacity. The indicator prediction module 302 is further configured to:
select, based on the feature sampling layer, historical charge/discharge currents and historical charge/discharge voltages at a plurality of distinct historical cycle counts from the performance characteristic as input to the feature classifier;
perform, based on each of the plurality of sub-feature classifiers, feature classification processing on a respective one of the historical charge/discharge currents and a respective one of the historical charge/discharge voltages at a respective one of the plurality of distinct historical cycle counts which are input to the each of the plurality of sub-feature classifiers, to obtain a feature classification result for the each of the plurality of sub-feature classifiers;
aggregate, based on the estimator, the feature classification result from the each of the plurality of sub-feature classifiers to generate an estimated result; and
perform, based on the result output layer, prediction processing on the estimated result to obtain a target battery capacity at a target cycle count.

In one embodiment, the indicator prediction module 302 is further configured to:
perform, based on the result output layer, the prediction processing on the estimated result to obtain a predicted battery capacity at the target cycle count;
calculate an average temperature of temperature data at the each historical cycle count; and
adjust the predicted battery capacity based on the average temperature to obtain the target battery capacity.

In another embodiment, the indicator prediction module 302 is further configured to:
for the each of the plurality of sub-feature classifiers, determine, based on the estimator, a count weight to a respective one of the plurality of distinct historical cycle counts;
perform, based on the estimator, weighted processing on the count weight and the feature classification result corresponding to the each of the plurality of sub-feature classifiers to obtain a weighted classification result for the each of the plurality of sub-feature classifiers; and
aggregate, based on the estimator, the weighted classification result for the each of the plurality of sub-feature classifiers to obtain the estimated result.

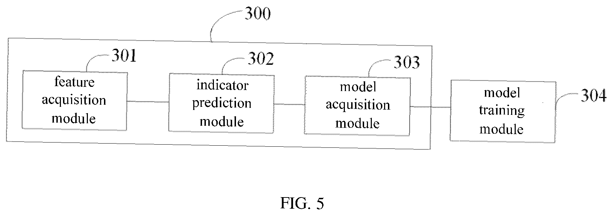

Referring to FIG. 5, which is another block diagram of the battery cycle performance prediction device according to embodiments of the present disclosure. The battery cycle performance prediction device 300 further includes a model acquisition module 303, which is communicatively connected to a model training module 304. The model training module 304 can be integrated into a model training device or integrated into the battery cycle performance prediction device 300.

In one embodiment, the model training module 304 is configured to:
acquire a sample battery training set. The sample battery training set includes cycle test feature sets for a plurality of sample batteries. Each of the cycle test feature sets of a respective one of the plurality of sample batteries includes an inherent performance characteristic of the respective one of the plurality of sample batteries measured for a single test cycle.
acquire a regression model to be trained; and
train the regression model to be trained based on the sample battery training set until a preset condition is met, obtaining a trained cycle performance prediction model.

In one embodiment, the model training module 304 is further configured to:
acquire a plurality of candidate hyperparameter combinations by traversing the regression model utilizing a network search algorithm;
partition a sample battery dataset into the sample battery training set and a sample battery validation set by adopting a cross-validation algorithm, and performing performance validation on the regression model under each of the plurality of candidate hyperparameter combinations to obtain a performance validation result for each candidate hyperparameter;
determining the target hyperparameter combination from the plurality of candidate hyperparameter combinations based on the performance validation result; and
construct the regression model to be trained based on the target hyperparameter combination.

In one embodiment, the performance characteristic of the regression model to be trained is acquired and includes battery capacity, cycle count, charge/discharge voltage, and charge/discharge current. The model training module 304 is further configured to:
train the regression model, taking the cycle count, charge/discharge voltage, and charge/discharge current of the each single test cycle in the sample battery training set as input of the regression model, the battery capacity of the each single test cycle as output of the regression model, until the preset condition is met, obtaining the cycle performance prediction model.

In one embodiment, when training of the regression model, the model training module 304 is further configured to:
assess performance of the cycle performance prediction model using an evaluation metric; wherein the evaluation metric includes at least one of mean squared error, root mean squared error, and coefficient of determination; or
evaluate the performance of the cycle performance prediction model by a scatter plot; wherein the scatter plot presents predicted values versus actual values of the cycle performance prediction model.

In one embodiment, the model training module 304 is further configured to:
acquire cycle test data of each of the plurality of sample batteries within a preset period. The each of the plurality of sample battery has one set of test data for the single test cycle;
perform data cleaning on the cycle test data of the each of the plurality of sample batteries to obtain processed cycle test data; and
from the processed cycle test data, determine inherent performance characteristics of the plurality of sample batteries to construct a sample battery feature set, and select the sample battery training set from the sample battery feature set.

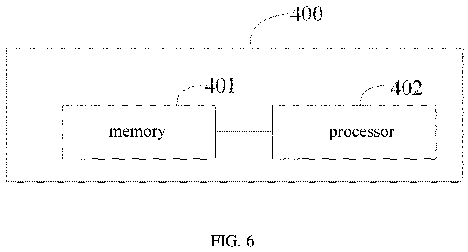

Referring to FIG. 6, FIG. 6 is a block diagram of an electronic equipment according to embodiments of the present disclosure. The electronic equipment is intended to represent any form of digital computer, such as a laptop, desktop computer, workstation, personal digital assistant, server, blade server, mainframe, or other suitable computers. The electronic equipment can also represent any form of mobile device, such as a personal digital assistant, cellular phone, smartphone, wearable device, or other similar computing device.

In the present disclosure, an electronic equipment is further provided. The electronic equipment 400 includes a memory 401 and a processor 402. The processor 402, by invoking one or more computer programs stored in the memory 401, is configured to perform the operations in the method for predicting battery cycle performance provided in the embodiments of the present disclosure.

One skilled in the art will understand that structure of the electronic equipment shown in FIG. 6 is not limiting to the electronic equipment. The electronic equipment may include more or fewer components than the structure shown in the figure, or may combine certain components or have different component arrangements.

Applications stored in the memory 401 contain the one or more computer programs. The processor 402, by running the one or more computer programs stored in the memory 401, performs functions, applications or data processing.

The processor 402 is a control center of the electronic equipment, connecting each part of the electronic equipment through interfaces and circuits. By running or executing the one or more computer programs stored in the memory 401 and invoking data stored in the memory 401, the processor performs functions of the electronic equipment and processes data, thereby providing overall monitoring of the electronic equipment.

In this embodiment, the processor 402 in the electronic equipment executes instructions below, loading executable code corresponding to one or more application processes into the memory 401, and executing applications stored in the memory 401 through the processor 402 to perform the following operations.

A performance characteristic of a battery to be tested is acquired from historical usage data of the battery to be tested.

Prediction processing is performed on the performance characteristic based on a cycle performance prediction model which is pre-trained to obtain a cycle performance indicator of the battery to be tested.

In one embodiment, when acquiring the performance characteristic of the battery to be tested from the historical usage data of the battery to be tested, the processor 402 performs the following operations. The historical usage data of the battery to be tested is acquired. The historical usage data includes charge/discharge voltage data, charge/discharge current data, battery capacity data, temperature data, and pressure data at each historical cycle count. Data cleaning is performed on the historical usage data to obtain processed historical usage data. The performance characteristic of the battery to be tested is determined based on the charge/discharge voltage data, charge/discharge current data, and battery capacity data at the each historical cycle count in the processed historical usage data.

In one embodiment, when performing prediction processing on the estimated result through the result output layer to obtain a target battery capacity at a target cycle count, the processor 402 performs the following operations. Based on the result output layer, the prediction processing is performed on the estimated result to obtain a predicted battery capacity at the target cycle count. An average temperature of temperature data at the each historical cycle count is calculated. The predicted battery capacity is adjusted based on the average temperature to obtain the target battery capacity.

In one embodiment, when aggregating, based on the estimator, the feature classification result from the each of the plurality of sub-feature classifiers to generate an estimated result, the processor 402 specifically performs the following operations. For the each of the plurality of sub-feature classifiers, based on the estimator, a count weight to a respective one of the plurality of distinct historical cycle counts is determined. Based on the estimator, weighted processing is performed on the count weight and the feature classification result corresponding to the each of the plurality of sub-feature classifiers to obtain a weighted classification result for the each of the plurality of sub-feature classifiers. Based on the estimator, the weighted classification result for the each of the plurality of sub-feature classifiers is aggregated to obtain the estimated result.

In one embodiment, before the cycle performance prediction model which is pre-trained is acquired, the processor 502 performs the following operations. A sample battery training set is acquired. The sample battery training set includes cycle test feature sets for a plurality of sample batteries. Each of the cycle test feature sets of a respective one of the plurality of sample batteries includes an inherent performance characteristic of the respective one of the plurality of sample batteries measured for a single test cycle. A regression model to be trained is acquired. The regression model to be trained is trained based on the sample battery training set until a preset condition is met, obtaining a trained cycle performance prediction model.

In one embodiment, when acquiring the regression model to be trained, the processor 502 performs the following operations. A plurality of candidate hyperparameter combinations is acquired by traversing the regression model utilizing a network search algorithm. A sample battery dataset is partitioned into the sample battery training set and a sample battery validation set by adopting a cross-validation algorithm, and performing performance validation on the regression model under each of the plurality of candidate hyperparameter combinations to obtain a performance validation result for each candidate hyperparameter. The target hyperparameter combination is determined from the plurality of candidate hyperparameter combinations based on the performance validation result. The regression model to be trained is constructed based on the target hyperparameter combination.

In one embodiment, when training the regression model to be trained based on the sample battery training set until a preset condition is met to obtain a trained cycle performance prediction model, the processor 502 performs the following operations. The regression model is trained, taking cycle count, charge/discharge voltage, and charge/discharge current of the each single test cycle in the sample battery training set as input of the regression model, battery capacity of the each single test cycle as output of the regression model, until the preset condition is met, obtaining the cycle performance prediction model. Specifically, the inherent performance characteristic of the regression model to be trained includes the battery capacity, cycle count, charge/discharge voltage, and charge/discharge current.

In one embodiment, when training the regression model, the processor 502 performs the following operations. Performance of the cycle performance prediction model is assessed using an evaluation metric. The evaluation metric includes at least one of mean squared error, root mean squared error, and coefficient of determination. Alternatively, the performance of the cycle performance prediction model is evaluated by a scatter plot. The scatter plot presents predicted values versus actual values of the cycle performance prediction model.

In one embodiment, before the sample battery training set is acquired, the processor 502 performs the following operations. Cycle test data of each of the plurality of sample batteries within a preset period is acquired. The each of the plurality of sample battery has one set of test data for the single test cycle. Data cleaning is performed on the cycle test data of the each of the plurality of sample batteries to obtain processed cycle test data. From the processed cycle test data, inherent performance characteristics of the plurality of sample batteries is determined to construct a sample battery feature set, and select the sample battery training set from the sample battery feature set.

In one embodiment, when performing prediction processing on the performance characteristic based on a cycle performance prediction model which is pre-trained to obtain a cycle performance indicator of the battery to be tested, the processor 502 performs the following operations. Based on a feature sampling layer, historical charge/discharge currents and historical charge/discharge voltages at a plurality of distinct historical cycle counts are selected from the performance characteristic as input to the feature classifier. Based on each of a plurality of sub-feature classifiers, feature classification processing is performed on a respective one of the historical charge/discharge currents and a respective one of the historical charge/discharge voltages at a respective one of the plurality of distinct historical cycle counts which are input to the each of the plurality of sub-feature classifiers, to obtain a feature classification result for the each of the plurality of sub-feature classifiers. Based on an estimator, the feature classification result is aggregated from the each of the plurality of sub-feature classifiers to generate an estimated result. Based on a result output layer, prediction processing is performed on the estimated result to obtain a target battery capacity at a target cycle count. Specifically, the cycle performance prediction model includes the feature sampling layer, feature classifier, estimator, and result output layer, the feature sampling layer, the feature classifier, the estimator, and the result output layer are connected in sequence, and the feature classifier includes the plurality of sub-feature classifiers arranged in parallel with each other. The performance characteristic includes historical cycle count, historical charge/discharge voltage, and historical charge/discharge current, and the cycle performance indicator is measured by battery capacity.

In all of above-mentioned embodiments, each description is focused on a specific aspect. For sections not elaborated on in a particular embodiment, reference can be made to the earlier detailed descriptions of the method for predicting battery cycle performance.

In some embodiments of the present disclosure, the electronic equipment and the method for predicting battery cycle performance provided in the previous embodiments belong to a same concept. The electronic equipment can perform any method provided in the embodiment for predicting battery cycle performance. Specific implementation process is detailed in the method embodiments, and it will not be repeated here.

It should be noted that, for the method of predicting battery cycle performance in some embodiments of the present disclosure, those skilled in the art will understand that the entire or part of the process of implementing the method for predicting battery cycle performance can be completed by controlling a relevant hardware through one or more computer programs. The one or more computer programs can be stored in a computer-readable storage medium, such as a disk, optical disk, read-only memory (ROM), random access memory (RAM), etc. The one or more computer programs can be executed by at least one processor. During execution, processes similar to the implementation flow of the method for predicting battery cycle performance can be performed.

In some embodiments of the present disclosure, a computer-readable storage medium is further provided. The computer-readable storage medium stores one or more computer programs, which, when executed on a computer, cause the computer to perform the processes outlined in the method for predicting battery cycle performance provided in the above-mentioned embodiments of the present disclosure.

## Claims

1. A method for predicting battery cycle performance, comprising:
acquiring a performance characteristic of a battery to be tested from historical usage data of the battery to be tested; and
performing prediction processing on the performance characteristic based on a cycle performance prediction model which is pre-trained to obtain a cycle performance indicator of the battery to be tested.

2. The method as claimed in claim 1, wherein the acquiring a performance characteristic of a battery to be tested from historical usage data of the battery to be tested comprises:
acquiring the historical usage data of the battery to be tested, wherein the historical usage data comprises charge/discharge voltage data, charge/discharge current data, battery capacity data, temperature data, and pressure data at each historical cycle count;
performing data cleaning on the historical usage data to obtain processed historical usage data; and
determining the performance characteristic of the battery to be tested based on the charge/discharge voltage data, charge/discharge current data, and battery capacity data at the each historical cycle count in the processed historical usage data.

3. The method as claimed in claim 2, wherein the cycle performance prediction model comprises a feature sampling layer, a feature classifier, an estimator, and a result output layer, the feature sampling layer, the feature classifier, the estimator, and the result output layer are connected in sequence, and the feature classifier comprises a plurality of sub-feature classifiers arranged in parallel with each other; the performance characteristic comprises historical cycle count, historical charge/discharge voltage, and historical charge/discharge current, and the cycle performance indicator is measured by battery capacity;
the performing prediction processing on the performance characteristic based on a cycle performance prediction model which is pre-trained to obtain a cycle performance indicator of the battery to be tested comprises:
selecting, based on the feature sampling layer, historical charge/discharge currents and historical charge/discharge voltages at a plurality of distinct historical cycle counts from the performance characteristic as input to the feature classifier;
performing, based on each of the plurality of sub-feature classifiers, feature classification processing on a respective one of the historical charge/discharge currents and a respective one of the historical charge/discharge voltages at a respective one of the plurality of distinct historical cycle counts which are input to the each of the plurality of sub-feature classifiers, to obtain a feature classification result for the each of the plurality of sub-feature classifiers;
aggregating, based on the estimator, the feature classification result from the each of the plurality of sub-feature classifiers to generate an estimated result; and
performing, based on the result output layer, prediction processing on the estimated result to obtain a target battery capacity at a target cycle count.

4. The method as claimed in claim 3, wherein the performing, based on the result output layer, prediction processing on the estimated result to obtain a target battery capacity at a target cycle count comprises:
performing, based on the result output layer, the prediction processing on the estimated result to obtain a predicted battery capacity at the target cycle count;
calculating an average temperature of temperature data at the each historical cycle count; and
adjusting the predicted battery capacity based on the average temperature to obtain the target battery capacity.

5. The method as claimed in claim 3, wherein the aggregating, based on the estimator, the feature classification result from the each of the plurality of sub-feature classifiers to generate an estimated result comprises:
for the each of the plurality of sub-feature classifiers, determining, based on the estimator, a count weight to a respective one of the plurality of distinct historical cycle counts;
performing, based on the estimator, weighted processing on the count weight and the feature classification result corresponding to the each of the plurality of sub-feature classifiers to obtain a weighted classification result for the each of the plurality of sub-feature classifiers; and
aggregating, based on the estimator, the weighted classification result for the each of the plurality of sub-feature classifiers to obtain the estimated result.

6. The method as claimed in any one of claims 1 to 5, wherein the cycle performance prediction model is obtained by training a regression model with a sample battery training set, the sample battery training set comprises cycle test feature sets of a plurality of sample batteries, and for each of the plurality of sample batteries, a respective one of the cycle test feature sets of a respective one of comprises battery capacity, cycle count, charge/discharge voltage, and charge/discharge current of the each of the plurality of sample batteries for each single test cycle;
when training the regression model, the cycle count, charge/discharge voltage, and charge/discharge current of the each single test cycle in the sample battery training set are taken as input of the regression model, the battery capacity of the each single test cycle is taken as output of the regression model, and the regression model is trained until a preset condition is met, obtaining the cycle performance prediction model.

7. The method as claimed in claim 6, wherein the regression model is constructed based on a target hyperparameter combination, and obtaining the target hyperparameter combination comprises:
acquiring a plurality of candidate hyperparameter combinations by traversing the regression model utilizing a network search algorithm;
partitioning a sample battery dataset into the sample battery training set and a sample battery validation set by adopting a cross-validation algorithm, and performing performance validation on the regression model under each of the plurality of candidate hyperparameter combinations to obtain a performance validation result for each candidate hyperparameter; and
determining the target hyperparameter combination from the plurality of candidate hyperparameter combinations based on the performance validation result.

8. The method as claimed in claim 6, wherein when training the regression model, the method further comprises:
assessing performance of the cycle performance prediction model using an evaluation metric; wherein the evaluation metric comprises at least one of mean squared error, root mean squared error, and coefficient of determination; or
evaluating the performance of the cycle performance prediction model is by a scatter plot; wherein the scatter plot presents predicted values versus actual values of the cycle performance prediction model.

9. An electronic equipment comprising:
a processor; and
a memory, storing one or more computer programs, which, when executed by the processor, cause the processor to perform the method as claimed in any one of claims 1 to 7.

10. A computer-readable storage medium storing one or more computer programs, which, when executed by a processor, cause the processor to perform the method as claimed in any one of claims 1 to 7.
